# EUROPEAN PATENT APPLICATION

(11) **EP 3 739 480 A1**
(43) Date of publication of application: **18.11.2020**
(21) Application number: 19174462.2
(22) Date of filing: 14.05.2019
(51) Int. Cl.: G06F 17/50, G06Q 10/06, G06Q 30/06

(54) **A METHOD OF EVALUATING A CAPABILITY OF A MACHINE AND DETERMINING A MACHINE RUN TIME FOR MANUFACTURING A PART**

(71) Applicant: Kreatize GmbH, 10405 Berlin (DE)
(72) Inventor: Tüchelmann, Simon, 10405 Berlin (DE)
(74) Representative: Dr. Langfinger & Partner

(57) **Abstract**

The present disclosure relates to a method of evaluating a capability of a machine and determining a machine run time for manufacturing a part, the method comprising:
a) receiving values of each of a plurality of physical feature characteristics of a part, comprising features representative for the removal of material from an initial form of the part to form the part;
b) receiving a range of values for each of the plurality of physical feature characteristics for one or more types of machines;
c) comparing each physical feature characteristic value of the part with the range of feature characteristic values for the one or more machines; and
d) determining a fit rating for each of the one or more machines based on the comparison, wherein similarities in the geometrical shape of removal of material from the initial shape are grouped and assigned to a particular machine; and wherein
e) the machine run time of the machine or the machines for the production of the part from its initial form are calculated by the method.

## Description

The present invention relates generally to the design and manufacturing of parts, and will be specifically disclosed as a method of evaluating a capability of a machine and determining a machine run time for manufacturing a specific part.

No technology currently exists that successfully connects design engineering directly with production technology. In the first step, design engineers do not have any automated way to evaluate the cost of producing parts or components they design. This includes of course the type of machines needed, the set-up time of these machines, the machine run time, material costs, etc.

Therefore, a manufacturing engineer has to conduct a cost evaluation as a separate exercise. In the absence of manufacturing data on materials and processes, the engineer normally uses a complexity factor on an older part performing the same or similar function. This technique is arbitrary, lacking a scientific basis for estimating cost.

Moreover, for the production of the designed parts, cost estimates have to be made by production companies in addition, doubling the work. In Germany, there are currently around 220,000 production companies in various industrial sectors, with a total of around 440,000 requests for quotation (RFQs) for parts per day.

Today, these requests for quotation are usually made manually by telephone, e-mail or fax and the associated calculations are carried out using "Excel" spreadsheets, if not manually. Since no errors are allowed to occur when ordering the often highly customized components, as the parts would otherwise not be usable, the RFQs must be performed by trained engineers.

For this reason, trained engineers in Germany spend approx. 1.8 million hours a day (on average 4 hours per RFQ) on requesting quotations for technical components. The biggest reason for this is that the processes involved in ordering components are by no means standardized today, so that approx. 80% of the time spent with the demand for quotations is wasted due to inefficient processes.

The time-consuming processes involved in requesting and producing technical components have an enormous impact on the entire production industry. Surface properties, material, edge conditions and geometric dimensions of the component play an enormous role in the subsequent use of the parts, so that there is no scope for deviations from the required properties.

From the point of view of the engineers placing the order, it is time-consuming to sketch or model the parts as accurately as possible and then transmit them to the suppliers accordingly, often with additional explanations. From the supplier's point of view, the first step is to calculate the effort required to manufacture the components and to check whether the necessary capacities are available for production. Especially for this, enormous empirical values are necessary today in order to be able to estimate the real effort and thus the costs. For the acceptance of production orders for technical components, therefore, the assessments of the respective managing directors of a supplier company are still often necessary today.

Some computer programs, such as PriceH (a commercially available system from Lockheed-Martin) and Compeat (proprietary to General Electric Aircraft Engines "GEAE"), exist and are based on comparative/parametric estimating, requiring historical data.

However, such approaches are deficient for advanced materials and processes where there is little or no historical data, or where the historical data is drastically different than the desired materials or processes. Moreover, manufacturing data on advanced materials and processes is hard to find, and the limited data available is often misleading if projected to maturity
without manufacturing technology assessment.

Furthermore, the above programs do not successfully link with the knowledge base of design engineering, making them awkward to use. Since the prior techniques for estimating costs are often deficient, engineers typically ignore the eventual cost of manufacturing, leaving it for the production department to control the cost.

Accordingly, an object of the invention is to provide a method and system of determining the machines needed for manufacturing a part, the machine run time and in case the materials needed and preferably estimating manufacturing costs.

A further problem is that several manufacturers have to be contacted with the pleas for cost estimates. This leads to the fact that the exact construction plans of components are spread more widely than necessary, comprising the risk of losing know-how to third parties.

Many methods are disclosed in the state of the art that in response to the insertion of a three-dimensional virtual geometry of a virtual model of a part into the computer-aided engine tries to analyze the geometry of the part precisely and to determine the machines needed and the machine run time for production of the part automatically.

By sending the accurate plans for parts around the world, the risk of losing know-how as outlined before is high. Therefore, one objective the present disclosure is to reduce the level of detail needed for a method to identify the best machines for production of a part and to estimate the machine run time needed.

Additional objectives, advantages and novel features of the invention will be set forth in the description that follows and, in part, will become apparent to those skilled in the art upon examining or practicing the invention. The objects and advantages of the invention may be realized and obtained by means of the instrumentalities and combinations particularly pointed out in the appended claims.

In particular, on object of the present invention is evaluating a capability of a machine and determining a machine run time for manufacturing a part automatically based on a drawing, natural language input or a CAD file, preferably with a less information about the part to be made as possible.

This object is solved by a method of evaluating a capability of a machine and determining a machine run time for manufacturing a part, the method comprising:
a) receiving values of each of a plurality of physical feature characteristics of a part, comprising features representative for the removal of material from an initial form of the part to form the part;
b) receiving a range of values for each of the plurality of physical feature characteristics for one or more types of machines;
c) comparing each physical feature characteristic value of the part with the range of feature characteristic values for the one or more machines; and
d) determining a fit rating for each of the one or more machines based on the comparison, wherein similarities in the geometrical shape of removal of material from the initial shape are grouped and assigned to a particular machine; and wherein
e) the machine run time of the machine or the machines for the production of the part from its initial form are calculated by the method.

The present disclosure describes computer implemented methods and systems, including machines for the automatic identification of a part, in particular based on a visual representation of the part or on a natural language description of the part, where the methods and systems involve computer programming to carry out one or more of the steps above.

Examples of these features characteristics of a part include material, e.g., which metal, height, width, and depth of the part, physical volume, number of cores, and characteristics of the drill holes.

Feature characteristic values for the one or more machines may involve machining specifications such as tolerances, smoothness, drill holes, drill hole volume, set-up time and parting line perimeter.

The machines itself may be milling machines, drilling machines, and all other types of machines, including CNC machines. The method may be used for various types of manufacturing methods (e.g., machining centers), such as for conventional machining (e.g., turning, milling), forming (e.g., spinning, stamping, punching), cutting (e.g., waterjet cutting, wire EDM, laser cutting), additive manufacturing (e.g., fused deposition modeling), welding and brazing, casting (e.g., sand casting, investment casting, die casting), injection molding, and/or other manufacturing and/or finishing processes supported by a manufacturing facility.

Therefore, according to one example of the present disclosure, there is a set of engineering specifications associated with each part and each machine as a basis for the calculation of the machine run time and for identifying the best machine for production of the part.

According to one example of the present disclosure, the for the calculation of the machine run time may contain per-unit-time setup time, such as time per unit to create or modify specialized tooling and fixtures, to load tooling and fixtures into machining centers, to generate machining or production files.

According to this example, the per-unit-time setup can be static, static per unit time for a particular type of work or operation, or variable over time. The per-unit-time setup can further include definitions to trigger manufacture of custom tooling and/or fixtures and associated (fixed or variable) costs based on costs to produce a certain number of units with and without such custom tooling and/or fixtures in addition to the time itself.

Therefore, in the first step, values of each of a plurality of physical feature characteristics of a part, comprising features representative for the removal of material from an initial form of the part to form the part are received.

In the next step b), which may as well be performed prior to step a), a range of values for each of the plurality of physical feature characteristics for one or more types of machines is received, e.g. for the type of machines outlined above.

Then, in the next steps, it is compared which machine fits best to create the part. Thereby, similarities in the geometrical shape of removal of material from the initial shape are grouped and assigned to a particular machine.

The advantage of the present method is that, compared to method for calculating a machine run time in the state of the art, the aggregated sum of physical feature characteristics is used to determine the machine run time, including according to one example the respective machine set-up time.

It has been shown that for calculating the machine run time it is sufficient to know the total amount of removed material from the initial state of a part and to separate the type of removal into milling and drilling, and in case other types of treatment of materials.

It may therefore be of advantage if the physical characteristic of the part comprises at least one of: height; volume; surface area; heat treatment; and tensile properties, in particular in its initial state and its condition after machining.

Thereby, it may be of advantage that the values of each of a plurality of physical feature characteristics of a part is retrieved from virtual model of the part, in particular in response to the insertion of a first three-dimensional virtual geometry of the virtual model of the part into a computer-aided drafting engine comprised by the method.

According to another example, it may be preferred that the values of each of a plurality of physical feature characteristics of a part is not retrieved from a virtual model of the part.

It may as well be possible according to one example, that the values of each of a plurality of physical feature characteristics of a part are entered by a user manually.

Thereby, it may be preferred that the features representative for the removal of material from an initial form of the part to form the part are entered aggregated by a user.

It may be preferred that according to one example of the method each type of characteristic value of the part feature is aggregated and each aggregated physical feature characteristic value of the part is compared with the range of feature characteristic values for the one or more machines.

Another surprising finding of the present disclosure is that the for the planning of a production of a part it is not necessary, even though it is of course possible, to receive a virtual model or accurate plans of the part. It may even be possible that just general information is provided to the method to identify the best types of machines and the respective machine run time.

Compared to methods in the state of the art it could be shown that it is sufficient to use aggregate values to optimize the selection of machines and to determine the machine run time.

It may thereby be preferred that the physical characteristic of the part comprises at least one of: the raw material size and the total removed volume.

It could be shown according to the present disclosure that the most relevant information needed is the raw material size and the total amount of removed volume from this raw material. Based on this amount of removed material, the machine run time could be calculated.

Thereby, it may be of advantage that the physical characteristic of the part comprises further: the amount of holes, the average hole diameter and in particular the average hole depth.

According to the present disclosure it could be shown that in most cases it is sufficient to determine the machine run time by separating the machines used in milling and drilling machines. It may thereby be possible that the amount of holes to be drilled is aggregated and the total depth of the holes is determined. It could be shown that the diameter of the holes is according to one example of the present disclosure of minor or even complete without relevance. The time to drill a hole is in most cases independent of the diameter.

It may of course be of advantage that different diameters of the holes are grouped separately as for different sizes respective machine set-up times have to be included into the machine run time calculations for changing the drills.

After aggregating the volume of material removal that can be created by drilling, the remaining volume must be removed by milling. According to one example of the present disclosure it could be shown that the amount of removal by milling could be easily calculated even without know the exact form of the part.

It may as well be of advantage according to one example that the physical characteristic of the part comprises further: the material density and in particular the tolerance of the removal of material.

A method according to any of the proceeding claims, wherein
the fit rating in step d) is determined dependent of a selection of the user prioritizing costs, production time and/or quality by entering an absolute or relative value input for one or each priority option.

Users will be offered several options when using the platform at a later date. Here the users should be able to indicate whether a prompt production and delivery of the components will be prioritized, the cheapest option, the optimal price-performance ratio or special manufacturers with great experience. This information flows into the neural network as a further input parameter. Within the network, the calculation for an optimal production solution of the component corresponding to the use case takes place after all input parameters have been recorded. For this purpose, the algorithm will access a database with the corresponding equipment of connected manufacturers. While within this concrete development project the system only knows which machines a manufacturer has, additional interfaces to common ERP systems are to be integrated in order to further optimize the solution in the future. For example, the potential is to be created to gain direct insight into the capacity utilization of a manufacturer's machines in the future, so that fully utilized manufacturers, for example, are not included in the calculations. The result of this calculation step of the algorithm is a list of suitable manufacturers for the required component with the specified priorities (prompt, favorable, etc.).

It may be preferred that before or while step a), the user enters a category for the type of the part.

According to one embodiment of the present disclosure it may be of advantage that the user roughly categorizes the type of part before uploading its component models or drawings in order to save the first sorting steps. By allowing users to sort their parts independently according to their industry, a system according to the method of the present disclosure can already indirectly be given information on how certain parameters have to be weighted and which features are typical for components in this industry.

For this purpose, it may be of advantage that a separate model may be set up for each category for the feature characteristic values for the one or more machines. According to one example, six different categories depending on the industry and therefore six different recognition models are of advantage. The models may be developed identically and then trained on industry-specific data sets. The training may be performed e.g. by machine learning, so that a higher level of accuracy can be achieved than with a single large model covering all types of industry in one.

The surprising finding of the present disclosure is that according to one embodiment, based on a virtual model of a part, a two-dimensional plan, or even just natural language descriptions of the part, the methods identifies identical ways of removal of material from the initial shape of a part and assigns said ways to separate machines.

It may be possible in one example of the present disclosure that the total amount of removal of material by milling from the initial shape of a part is entered by a user and the amount of holes, including different sizes and the average depth of the holes, to calculate a machine run time precisely.

Other priorities could be added by the user in addition, and of course further information like the type of material, density, etc. to make the calculations even more accurate.

Finally, the disclosure discloses a computer-readable storage medium containing instructions for performing a method according to the present disclosure and a use of a method according to the present disclosure or a computer-readable storage medium according to the present disclosure for selection machines and determining the machine run time for producing a part.

The foregoing aspects and many of the attendant advantages of this invention will become more readily appreciated as the same become better understood by reference to the following detailed description, when taken in conjunction with the accompanying drawing, wherein:

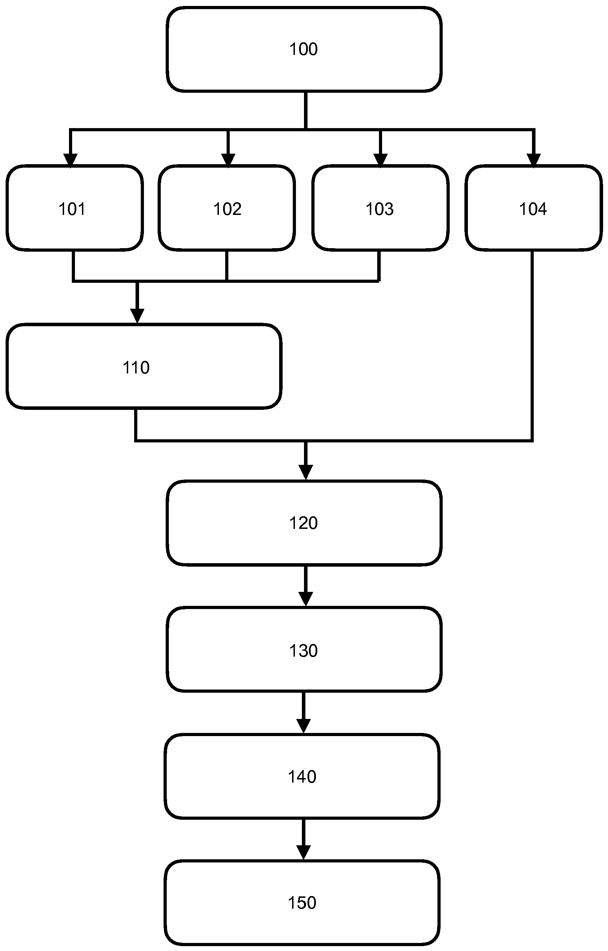

FIG. 1 is a schematic block diagram of an example of the method according to an embodiment.

The various embodiments will be described in detail with reference to the accompanying drawings. Wherever possible, the same reference numbers will be used throughout the drawings to refer to the same or like parts. References made to particular examples and implementations are for illustrative purposes, and are not intended to limit the scope of the invention or the claims.

While illustrative examples are illustrated and described below, it will be appreciated that various changes can be made therein without departing from the spirit and scope of the disclosure. In that regard, the detailed description set forth below, in connection with the appended drawings is intended only as a description of various examples of the disclosed subject matter and is not intended to represent the only examples. Each example described in this disclosure is provided merely as an example or illustration and should not be construed as preferred or advantageous over other examples. The illustrative examples provided herein are not intended to be exhaustive or to limit the disclosure to the precise forms disclosed. Similarly, any steps described herein may be interchangeable with other steps, or combinations of steps, in order to achieve the same or substantially similar result.

Figure 1 shows a diagram 100 illustrating an exemplarily example of the method according to the present disclosure.

In a first step 100, the method receives values of each of a plurality of physical feature characteristics of a part, comprising features representative for the removal of material from an initial form of the part to form the part.

That plurality of physical feature characteristics of the part may include material, e.g., which metal, height, width, and depth of the part, physical volume, number of cores, and characteristics of the drill holes.

Thereby, it may be of advantage that the values of each of a plurality of physical feature characteristics of a part is retrieved from virtual model of the part in a step 101, in particular in response to the insertion of a first three-dimensional virtual geometry of the virtual model of the part into a computer-aided drafting engine comprised by the method.

In the alternative, it is also possible to use a two-dimensional drawing in a step 102 or that a user describes the part in natural language in a step 103.

One of the surprising finding of the present disclosure is that the for the planning of a production of a part it is not necessary to receive a virtual model or accurate plans of the part.

It may even be possible that just general information is provided to the method to identify the best types of machines and the respective machine run time.

Compared to methods in the state of the art it could be shown that it is sufficient to use aggregate values to optimize the selection of machines and to determine the machine run time, which could be directly be entered by a user in a step 104.

If the user directly enters the aggregated values in a step 104, the aggregation step 110 could be skipped, and the method continues with step 120.

It could be shown by the present disclosure that in most cases it is sufficient to determine an aggregation of material removal steps. For example, it is identified which material could be removed by milling or drilling and then for example in step 110 the amount of holes with the same diameter to be drilled is grouped an aggregated, and in addition the volume of material to be removed by milling.

For example, after aggregating the volume of material removal that can be created by drilling, the remaining volume must be removed by milling or by other machines. It may make sense to start with a drilling machine, as this machine may be the easiest and fastest possibly for material removal.

Therefore, in accordance with step 104, the amount of removal by milling could be easily calculated even without know the exact form of the part.

In a next step 120, which may as well be performed prior to step 100, 101, 102, 103, 104 or 110, a range of values for each of the plurality of physical feature characteristics for one or more types of machines is received, e.g. for the type of machines outlined above

This step may involve machining specifications such as tolerances, smoothness, drill holes, drill hole volume, set-up time and parting line perimeter.

The machines itself may be milling machines, drilling machines, and all other types of machines, including CNC machines. The method may be used for various types of manufacturing methods (e.g., machining centers), such as for conventional machining (e.g., turning, milling), forming (e.g., spinning, stamping, punching), cutting (e.g., waterjet cutting, wire EDM, laser cutting), additive manufacturing (e.g., fused deposition modeling), welding and brazing, casting (e.g., sand casting, investment casting, die casting), injection molding, and/or other manufacturing and/or finishing processes supported by a manufacturing facility.

In the result, according to one example of the present disclosure, there is a set of engineering specifications associated with each part and each machine as a basis for the calculation of the machine run time and for identifying the best machine for production of the part.

According to one example of the present disclosure, the for the calculation of the machine run time may contain per-unit-time setup time, such as time per unit to create or modify specialized tooling and fixtures, to load tooling and fixtures into machining centers, to generate machining or production files.

This is for example of relevance if 10 holes must be drilled. It is a huge difference if all 10 have the same diameter, which means the same drill could be used, or if they have all a different diameter, so that 10 different drills are used, requiring each a set-up time that have to be taken into account.

In the latter case, it may be faster to use a milling machine for all the material removal, even though drilling is in general faster.

Thereby, the per-unit-time setup can be static, static per unit time for a particular type of work or operation, or variable over time. The per-unit-time setup can further include definitions to trigger manufacture of custom tooling and/or fixtures and associated (fixed or variable) costs based on costs to produce a certain number of units with and without such custom tooling and/or fixtures in addition to the time itself.

In the next step 130, the method is comparing each physical feature characteristic value of the part with the range of feature characteristic values for the one or more machines.

In a subsequent step 140, a fit rating for each of the one or more machines based on the comparison is determined, wherein similarities in the geometrical shape of removal of material from the initial shape are grouped and assigned to a particular machine.

In the step 130, it is compared which machine fits best to create the part. Thereby, similarities in the geometrical shape of removal of material from the initial shape are grouped and assigned to a particular machine.

The advantage of the present method is that, compared to method for calculating a machine run time in the state of the art, the aggregated sum of physical feature characteristics is used to determine the machine run time, including according to one example the respective machine set-up time.

It has been shown that for calculating the machine run time it is sufficient to know the total amount of removed material from the initial state of a part and to separate the type of removal into milling and drilling, and in case other types of treatment of materials.

It may therefore be of advantage if the physical characteristic of the part comprises at least one of: height; volume; surface area; heat treatment; and tensile properties, in particular in its initial state and its condition after machining.

Finally, in a step 150 the machine run time of the machine or the machines for the production of the part from its initial form are calculated by the method.

The foregoing method descriptions and the process flow diagrams are provided merely as illustrative examples and are not intended to require or imply that the steps of the various embodiments must be performed in the order presented. As will be appreciated by one of skill in the art the order of steps in the foregoing embodiments may be performed in any order. Words such as "thereafter," "then," "next," etc. are not intended to limit the order of the steps; these words are simply used to guide the reader through the description of the methods. Further, any reference to claim elements in the singular, for example, using the articles "a," "an" or "the" is not to be construed as limiting the element to the singular.

The various illustrative logical blocks, modules, circuits, and algorithm steps described in connection with the embodiments disclosed herein may be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the present invention.

The hardware used to implement the various illustrative logics, logical blocks, modules, and circuits described in connection with the aspects disclosed herein may be implemented or performed with a general purpose processor, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A general-purpose processor may be a microprocessor, but, in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration. Alternatively, some steps or methods may be performed by circuitry that is specific to a given function.

In one or more exemplary aspects, the functions described may be implemented in hardware, software, firmware, or any combination thereof. If implemented in software, the functions may be stored as one or more instructions or code on a non-transitory computer-readable medium or non-transitory processor-readable medium. The steps of a method or algorithm disclosed herein may be embodied in a processor-executable software module which may reside on a non-transitory computer-readable or processor-readable storage medium. Non-transitory computer-readable or processor-readable storage media may be any storage media that may be accessed by a computer or a processor. By way of example but not limitation, such non-transitory computer-readable or processor- readable media may include RAM, ROM, EEPROM, FLASH memory, CD- ROM or other optical disk storage, magnetic disk storage or other magnetic storage devices, or any other medium that may be used to store desired program code in the form of instructions or data structures and that may be accessed by a computer. Disk and disc, as used herein, includes compact disc (CD), laser disc, optical disc, digital versatile disc (DVD), floppy disk, and blu-ray disc where disks usually reproduce data magnetically, while discs reproduce data optically with lasers. Combinations of the above are also included within the scope of non-transitory computer-readable and processor-readable media. Additionally, the operations of a method or algorithm may reside as one or any combination or set of codes and/or instructions on a non-transitory processor-readable medium and/or computer-readable medium, which may be incorporated into a computer program product.

The given examples of cleaning workers are provided to ease the understanding of the disclosure of the present application only. It is obvious for those skilled in the art that other tasks might be assigned as well to different users.

## Claims

1. A method of evaluating a capability of a machine and determining a machine run time for manufacturing a part, the method comprising:
a) receiving values of each of a plurality of physical feature characteristics of a part, comprising features representative for the removal of material from an initial form of the part to form the part;
b) receiving a range of values for each of the plurality of physical feature characteristics for one or more types of machines;
c) comparing each physical feature characteristic value of the part with the range of feature characteristic values for the one or more machines; and
d) determining a fit rating for each of the one or more machines based on the comparison, wherein similarities in the geometrical shape of removal of material from the initial shape are grouped and assigned to a particular machine; and wherein
e) the machine run time of the machine or the machines for the production of the part from its initial form are calculated by the method.

2. The method according to claim 1, wherein
the physical characteristic of the part comprises at least one of:
height; volume; surface area; heat treatment; and tensile properties, in particular in its initial state and its condition after machining.

3. The method according to claim 1 or claim 2, wherein
the values of each of a plurality of physical feature characteristics of a part is retrieved from virtual model of the part, in particular in response to the insertion of a first three-dimensional virtual geometry of the virtual model of the part into a computer-aided drafting engine comprised by the method.

4. A method according to any of the preceding claims, wherein
the values of each of a plurality of physical feature characteristics of a part is not retrieved from a virtual model of the part.

5. A method according to any of the preceding claims, wherein
the values of each of a plurality of physical feature characteristics of a part are entered by a user manually.

6. A method according to any of the preceding claims, wherein
features representative for the removal of material from an initial form of the part to form the part are entered aggregated by a user.

7. A method according to any of the preceding claims, wherein in step c) aggregating each type of characteristic value of the part feature and comparing each aggregated physical feature characteristic value of the part with the range of feature characteristic values for the one or more machines.

8. A method according to claim 6 or 7, wherein
the physical characteristic of the part comprises at least one of:
the raw material size and the total removed volume.

9. The method according to claim 8, wherein
the physical characteristic of the part comprises further:
the amount of holes, the average hole diameter and in particular the average hole depth.

10. The method according to claim 8 or 9, wherein
the physical characteristic of the part comprises further:
the material density and in particular the tolerance of the removal of material.

11. A method according to any of the preceding claims, wherein in step d) for assigning more than one machine the machine set up time of the machines is considered.

12. A method according to any of the proceeding claims, wherein
the fit rating in step d) is determined dependent of a selection of the user prioritizing costs, production time and/or quality by entering an absolute or relative value input for one or each priority option.

13. A method according to any of the proceeding claims, wherein
before or while step a), the user enters a category for the type of the part.

14. A computer-readable storage medium containing instructions for performing a method according to one of the preceding claims.

15. Use of a method according to any of the claims 1 to 13 or a computer-readable storage medium according to claim 14 for selecting machines and determining the machine run time for producing a part.
